# EUROPÄISCHE PATENTSCHRIFT

(11) **EP 1 910 631 B1**
(45) Veröffentlichungstag und Bekanntmachung des Hinweises auf die Patenterteilung: **21.07.2010**
(21) Anmeldenummer: 06792544.6
(22) Anmeldetag: 21.07.2006
(51) Int. Cl.: E05B 17/22, E05B 65/20, E05B 7/00, G07C 9/00, H03K 17/955

(54) **SENSORANORDNUNG FÜR EINE KRAFTFAHRZEUGSCHLIESSEINRICHTUNG UND ZUGEHÖRIGES VERFAHREN**
SENSOR ARRANGEMENT FOR A MOTOR-VEHICLE LOCKING DEVICE AND AN ASSOCIATED METHOD
DISPOSITIF DE DETECTEUR POUR SYSTEME DE FERMETURE D'UN VEHICULE AUTOMOBILE, ET PROCEDE ASSOCIE

(30) Priorität: 26.07.2005 DE 102005035479; 18.11.2005 DE 102005055515
(43) Veröffentlichungstag der Anmeldung: 16.04.2008
(73) Patentinhaber: Huf Hülsbeck & Fürst GmbH & Co. KG, 42551 Velbert (DE)
(72) Erfinder: WITTE, Martin, 48683 Ahaus (DE); SCHUMACHER, Helmut, 48653 Coesfeld (DE)
(74) Vertreter: Bongards, Jochen
(86) Internationale Anmeldenummer: PCT/EP2006/064535
(87) Internationale Veröffentlichungsnummer: WO 2007/012613

(56) Entgegenhaltungen:
- EP-A- 1 339 025
- EP-A- 1 505 734
- EP-A2- 0 954 098
- WO-A-01/40607
- DE-A1- 10 159 336
- DE-A1- 10 204 025
- DE-A1-102004 019 571

## Beschreibung

Die Erfindung betrifft eine Sensoranordnung zum Erfassen des Aufliegens eines Bedienerkörperteils auf einer Betätigungsstelle einer Schließeinrichtung eines Kraftfahrzeugs, mit einem Annäherungssensor, der so angeordnet ist, daß der Annäherungssensor eine Annäherung des Bedienerkörperteils an die Betätigungsstelle erfassen kann, mit einem an der Betätigungsstelle angeordneten mechanischen Sensor, der eine Änderung einer von dem Bedienerkörperteil auf die Betätigungsstelle ausgeübten Druckkraft erfassen kann, und mit einer Auswerteschaltung, die in Abhängigkeit von den Sensorausgangssignalen des Annäherungssensors und des mechanischen Sensors ein das Aufliegen des Bedienerkörperteils anzeigendes Ausgabesignal erzeugen kann. Ferner betrifft die Erfindung ein Verfahren zum Erfassen des Aufliegens eines Bedienerkörperteils auf einer Betätigungsstelle einer Schließeinrichtung eines Kraftfahrzeugs, wobei mit einem Annäherungssensor eine Annäherung des Bedienerkörperteils an die Betätigungsstelle erfaßt wird, mit einem an der Betätigungsstelle angeordneten mechanischen Sensor eine Änderung einer von dem Bedienerkörperteil auf die Betätigungsstelle ausgeübten Druckkraft erfaßt wird und von einer Auswerteschaltung in Abhängigkeit von den Sensorausgangssignalen des Annäherungssensors und des mechanischen Sensors ein das Aufliegen des Bedienerkörperteils anzeigendes Ausgabesignal erzeugt wird.

Eine Sensoranordnung bzw. ein Verfahren der eingangs genannten Art sind aus der nicht vor veröffentlichten Patentanmeldung DE 10 2004 019 571, die gemäß dem PCT als WO 2007/106 163 veröffentlicht wurde, bekannt. Die in dieser Patentanmeldung beschriebene Vorrichtung geht aus von einer Schließeinrichtung eines Fahrzeugs, bei dem in einem Türgriff kapazitive Sensoren untergebracht sind, die auf eine Annäherung eines Bedienerkörperteils, insbesondere einer Hand, ansprechen. Die kapazitiven Sensoren umfassen jeweils eine Elektrode in Form einer Metallfläche oder Metallplatte, eine mit der Elektrode gekoppelte Speise- und Auswerteschaltung und - als Referenzelektrode - eine Kopplung mit der Masse des Kraftfahrzeugs. Es sind eine Vielzahl unterschiedlichster Speise- und Auswerteschaltungen für den kapazitiven Sensor denkbar. Beispielsweise kann die aus der Elektrode und der Referenzmasse gebildete Kapazität mit einer Gleichspannung oder einer hochfrequenten Wechselspannung gespeist werden. Die jeweils vorhandene Kapazität (oder - bei Wechselspannung - Impedanz) bzw. deren Änderung wird von der Auswerteschaltung erfaßt. Änderungen der Kapazität ergeben sich beispielsweise durch die Annäherung der Hand eines Bedieners an die Elektrode. Diese Änderungen der Kapazität resultieren aus den Änderungen des elektrischen Feldes, welches sich zwischen der Elektrode und der Masse ausbildet. Grundsätzlich führt die Annäherung eines Bedienerkörperteils an die Elektrode zu einer Erhöhung der Kapazität. Diese Kapazitätserhöhung wird beispielsweise mit Hilfe eines Komparators ermittelt, der einen für die Kapazität repräsentativen Spannungs- oder Stromwert innerhalb der Auswerteschaltung mit einem Schwellwert vergleicht und in Abhängigkeit von dem Vergleich ein Ausgabesignal erzeugt.

Wird mit Hilfe des kapazitiven Sensors eine Annäherung einer Hand festgestellt, so löst ein diese Annäherung anzeigendes Ausgabesignal eine Kommunikation zwischen einer Steuereinrichtung im Kraftfahrzeug und einem ID-Geber ("Schlüssel"), den der Bediener bei sich führt, aus, wobei dann, wenn im Ergebnis dieser Kommunikation zwischen Kraftfahrzeug und ID-Geber festgestellt wird, daß dieser ID-Geber Zugangsberechtigung verleiht, eine Schließeinrichtung an der Tür des Kraftfahrzeugs derart betätigt wird, daß entweder (bei gewünschtem Zugang) ein Türgriff derart freigegeben wird, daß ein Ziehen an dem Türgriff ein Öffnen der Tür bewirkt, oder die Schließeinrichtung verriegelt wird, so daß ein Ziehen am Türgriff wirkungslos ist. Üblicherweise gibt es an dem Türgriff zwei kapazitive Sensoren bzw. zwei Elektrodenanordnungen. Ein erster kapazitiver Sensor, dessen Elektrode vorzugsweise an der der Kraftfahrzeugtür zugewandten Innenseite des Türgriffs angeordnet ist, bewirkt nach Erfassen einer Annäherung der Hand eine Freigabe der Schließeinrichtung, so daß bei anschließendem Ziehen des Türgriffs die Tür geöffnet werden kann. Ein zweiter kapazitiver Sensor, dessen Elektrode vorzugsweise an der Außenseite oder Oberseite des Türgriffs angeordnet ist und der vorzugsweise durch Auflegen des Daumens betätigt wird, bewirkt bei Erfassen seiner Betätigung eine Verriegelung der Schließeinrichtung, so daß ein Ziehen am Türgriff unwirksam bleibt.

Für beide kapazitive Sensoren ist es erwünscht, Fehlauslösungen zu vermeiden, die entweder durch Annäherung oder Berührung durch ein anderes Objekt, wie beispielsweise ein fallendes Blatt, oder durch andere Einflüsse, wie beispielsweise Regen, Schnee, Eis und Verschmutzungen, hervorgerufen werden.

Bei dem die Verriegelung bewirkenden zweiten kapazitiven Sensor ist es ferner erwünscht, daß dieser nicht auf das bloße Auflegen der Hand auf den Türgriff, sondern nur durch das gezielte Berühren einer kleinen Betätigungsstelle am Türgriff ausgelöst wird.

Bei einer bekannten Schließvorrichtung mit einem kapazitiven Sensor (DE 196 20 059 A1) werden nicht nur die Größe oder der Betrag der Änderung der Kapazität sondern auch die Geschwindigkeit der Änderung ermittelt, um eine Annäherung oder Berührung durch die Hand sicherer festzustellen. Der Sensor spricht hierbei lediglich auf eine relativ schnelle Kapazitätsänderung an, wie sie für eine Annäherung einer Bedienerhand typisch ist, nicht aber auf langsamere Kapazitätsänderungen, die beispielsweise aus Wettereinflüssen und Verschmutzungen resultieren. Eine solche Vorgehensweise ist in der Regel für den die Entriegelung der Schließeinrichtung bewirkenden ersten kapazitiven Sensor ausreichend.

Der die Verriegelung bewirkende zweite kapazitive Sensor wird häufig für die Ansteuerung sogenannter Komfortfunktionen eingesetzt. Dabei handelt es sich beispielsweise um das Schließen geöffneter Fenster, das Einschalten einer Alarmanlage, das Zufahren eines Fahrzeugverdecks und/oder das Einklappen von Seitenspiegeln, wobei diese Funktionen gleichzeitig mit der Verriegelung der Schließeinrichtung ausgelöst werden sollen. Das Schließen der Fenster und das Zufahren eines Fahrzeugverdecks sind jedoch Vorgänge, die eine gewisse Zeit benötigen. Dabei ist es häufig vorgesehen, daß diese Funktionen nur ausgeführt oder fortgesetzt werden, solange der die Funktionen auslösende Sensor von dem Bediener betätigt wird, d.h., solange der Bediener den Finger auf die Betätigungsstelle legt. Sobald der Bediener jedoch seinen Finger von der Betätigungsstelle wegnimmt, sollen die Komfortbetätigungen von beweglichen Bauteilen unterbrochen werden, beispielsweise das Schließen der Fenster oder das Zufahren des Verdecks gestoppt werden.

Dazu ist es jedoch erforderlich, nicht nur den Beginn der Betätigung des kapazitiven Sensors, sondern auch das Ende der Betätigung (d.h. die Wegnahme des Bedienerkörperteils) sicher zu erfassen. Dies ist mit der aus der Patentanmeldung DE 10 2004 019 571 bekannten Sensoranordnung nicht immer möglich. Die dort vorgeschlagene zusätzliche Anbringung eines eine Andruckkraft des Bedienerkörperteils auf die Betätigungsstelle erfassenden mechanischen Hilfssensors in Form eines piezoelektrischen Sensors gestattet zwar eine bessere Erfassung des Auflegens der Hand nach kombinierter Auswertung der Sensorausgangssignale des kapazitiven Sensors und des piezoelektrischen Sensors. Der piezoelektrische Sensor gibt jedoch nur dann auswertbare Signale aus, wenn sich die Betätigungskraft ändert. Dies ist beim Auflegen des Fingers auf die Betätigungsstelle der Fall (sprunghafte Erhöhung der Andruckkraft). Wenn jedoch der Finger dann auf der Betätigungsstelle liegen bleibt, ändert sich die Andruckkraft unvorhersagbar (beispielsweise Nachlassen der Andruckkraft oder schwankende Zu- und Abnahme der Kraft), so daß eine Auswertung des Signals keine sichere Erfassung der Wegnahme des Fingers gestattet. Das Aufliegen bzw. Wegnehmen des Bedienerkörperteils (Fingers) kann dann nur noch mit Hilfe des Ausgangssignals des kapazitiven Sensors erfaßt werden. Dieses Ausgangssignal wird überwacht und sobald festgestellt wird, daß die Kapazität unter einen Schwellwert absinkt, wird von einer Wegnahme des Bedienerkörperteils (Fingers) ausgegangen, wobei dann ggf. die Komfortbetätigungen von beweglichen Bauteilen unterbrochen werden. Der Schwellwert, mit dem das Ausgangssignal des kapazitiven Sensors verglichen wird, ist dabei so zu wählen, daß unabhängig von Änderungen der Umwelteinflüsse (insbesondere Feuchtigkeit und Verschmutzung) eine Erfassung der Annäherung des Bedienerkörperteils möglich ist. Darüber hinaus ist zu beachten, daß die Annäherung des Bedienerkörperteils (beispielsweise Fingers) nicht immer mit der gleichen Kapazitätserhöhung einhergeht. Beispielsweise ist die Kapazitätserhöhung deutlich geringer, wenn der Bediener (beispielsweise im Winter) Handschuhe trägt. Diesen Umstand berücksichtigend wird der Schwellwert ausreichend tief gesetzt.

Bei einem solchen tiefen und konstanten Schwellwert kann nun aber der Fall eintreten, daß zwar die Erhöhung der Kapazität bei Annäherung des Bedienerkörperteils (Fingers) sicher erfaßt wird, nicht aber die Wegnahme des Bedienerkörperteils. Diese fehlerhafte Nicht-Erkennung der Wegnahme des Bedienerkörperteils kann insbesondere dann auftreten, wenn beispielsweise der Finger des Bedieners feucht und ggf. verschmutzt ist, so daß nach der Wegnahme des Fingers von der Betätigungsstelle dort leitfähige Schmutz- und Wasserreste verbleiben, die aufgrund der Kopplung mit der (beispielsweise auf Masse gelegten) Griffumgebung eine deutliche höhere Kapazität ergeben, als sie vor der Annäherung des Bedienerkörperteils vorhanden war. Möglicherweise sinkt die Kapazität trotz Wegnehmens des Bedienerkörperteils nicht unter die vorgegebene Schwelle, so daß die Wegnahme nicht erfaßt wird.

Aufgabe der Erfindung ist es, die Sensoranordnung bzw. das Verfahren der eingangs genannten Art so zu verbessern, daß die Sicherheit des Erfassens der Wegnahme des Bedienerkörperteils erhöht wird.

Diese Aufgabe wird erfindungsgemäß durch eine Sensoranordnung mit den Merkmalen des Patentanspruchs 1 bzw. ein Verfahren mit den Merkmalen des Patentanspruchs 9 gelöst.

Die Sensoranordnung der eingangs genannten Art ist erfindungsgemäß dadurch gekennzeichnet, daß die Auswerteschaltung dann, wenn das Sensorausgangssignal des mechanischen Sensors den Beginn des Aufliegens des Bedienerkörperteils anzeigt, einen etwa gleichzeitig vom Annäherungssensor ausgegebenen Sensorausgangssignalwert für eine Auswertung der nachfolgenden Änderungen des Sensorausgangssignals des Annäherungssensors heranzieht, um ein Wegnehmen des Bedienerkörperteils von der Betätigungsstelle sicherer Erfassen zu können. Das eingangs genannte Verfahren zum Erfassen des Aufliegens eines Bedienerkörperteils auf einer Betätigungsstelle einer Schließeinrichtung eines Kraftfahrzeugs ist erfindungsgemäß dadurch gekennzeichnet, daß dann, wenn von der Auswerteschaltung aufgrund des Sensorausgangssignals des mechanischen Sensors der Beginn des Aufliegens des Bedienerkörperteils erfaßt wird, ein etwa gleichzeitig vom Annäherungssensor ausgegebener Sensorausgangssignalwert erfaßt und für eine Auswertung der nachfolgenden Änderungen des Sensorausgangssignals des Annäherungssensors herangezogen wird, um ein Wegnehmen des Bedienerkörperteils von der Betätigungsstelle sicherer erfassen zu können. Der Annäherungssensor ist vorzugsweise ein kapazitiver Annäherungssensor, der wenigstens eine Elektrode aufweist, die so angeordnet ist, daß der Annäherungssensor eine Annäherung an die Betätigungsstelle erfassen kann.

Der Erfindung liegt die Erkenntnis zugrunde, daß die Auswertung der Änderungen des Sensorausgangssignals des Annäherungssensors von einem als Referenzwert dienenden Sensorausgangssignalwert des Sensors abhängig gemacht werden sollte, der zu einem Zeitpunkt erfaßt wird, bei dem mit hoher Sicherheit vom Aufliegen des betätigenden Bedienerkörperteils ausgegangen werden kann. Vom Aufliegen des Bedienerkörperteils kann dann mit höchster Sicherheit ausgegangen werden, wenn der mechanische Hilfssensor den Beginn des Aufliegens des Bedienerkörperteils erfaßt, weil insbesondere beim anfänglichen Andrücken des Bedienerkörperteils (Fingers) auf die Betätigungsstelle eine signifikante Änderung des Ausgangssignals des mechanischen Sensors auftritt. Sobald das Sensorausgangssignal des mechanischen Sensors den Beginn des Aufliegens, d. h. das Andrücken des Bedienerkörperteils anzeigt, kann beispielsweise bei einem kapazitiven Annäherungssensor davon ausgegangen werden, daß der Annäherungssensor eine Kapazität hat, die näherungsweise der bei der Betätigung erreichbaren höchsten Kapazität entspricht (selbstverständlich kann die Kapazität noch geringfügig gesteigert werden, wenn das Bedienerkörperteil sich auf der Betätigungsstelle verschiebt oder noch stärker und großflächiger angepreßt wird). Etwa gleichzeitig mit dem Erfassen des Beginns des Aufliegens wird der gerade vom Annäherungssensor ausgegebene Sensorausgangssignalwert erfaßt und dann für die Auswertung der nachfolgenden Änderungen des Sensorausgangssignals des Annäherungssensors herangezogen. Zwischen dem Erfassen des Beginns des Aufliegens des Bedienerkörperteils und der etwa gleichzeitigen Erfassung des Sensorausgangssignalwerts des Annäherungssensors kann eine geringfügige Zeitverzögerung vorhanden sein, ohne daß die Funktion beeinträchtigt wird. Die zeitliche Verzögerung darf jedoch nicht größer sein als die geringste zu erwartende Betätigungsdauer der Sensoranordnung.

Die Betätigungsstelle kann sich auf einem Türgriff, an einer Heckklappe, an einem Handschuhkasten, auf einer Start-Stop-Einheit und/oder anderen Bedienstellen im Kraftfahrzeuginnenraum befinden.

Bei einer bevorzugten Ausführungsform der Sensoranordnung bzw. des Verfahrens zum Erfassen des Aufliegens eines Bedienerkörperteils auf einer Betätigungsstelle einer Schließeinrichtung eines Kraftfahrzeugs zeigt das Sensorausgangssignal des mechanischen Sensors den Beginn des Aufliegens des Bedienerkörperteils an, indem es mit einer sprunghaften Signaländerung eine sprunghafte Zunahme der ausgeübten Druckkraft anzeigt. Das Auflegen des Bedienerkörperteils ist regelmäßig durch eine sprunghafte Zunahme der ausgeübten Druckkraft gekennzeichnet. Der mechanische Sensor reagiert auf die sprunghafte Zunahme der Druckkraft mit einer sprunghaften Signaländerung, beispielsweise einem kurzzeitigen Spannungsimpuls.

Bei einer bevorzugten Ausführungsform wird der gleichzeitig von dem Annäherungssensor ausgegebene Sensorausgangssignalwert erfaßt und für eine Auswertung der nachfolgenden Änderungen des Sensorausgangssignals des Annäherungssensors herangezogen, indem (i) aus dem gleichzeitig vom Annäherungssensor ausgegebenen Sensorausgangssignalwert ein Schwellwert abgeleitet wird, (ii) nachfolgend das Sensorausgangssignal des Annäherungssensors mit dem Schwellwert verglichen wird, und (iii) eine das Wegnehmen des Bedienerkörperteils anzeigende Änderung des Ausgabesignals erzeugt wird, sobald das Sensorausgangssignal des Sensors den Schwellwert unterschreitet. Alternativ kann beim umgekehrten Abhängigkeiten auch ein Überschreiten des Schwellwerts erfaßt werden. Der Schwellwert wird aus dem Sensorausgangssignalwert beispielsweise dadurch abgeleitet, daß eine vorgegebene Spannung von dem Sensorausgangssignalwert subtrahiert wird. Die Ableitung des Schwellwerts und der nachfolgende Vergleich können sowohl im analogen Bereich als auch- nach entsprechender Umsetzung der Spannungswerte in Digitalwerte - im digitalen Bereich programmgesteuert erfolgen. Bei der beschriebenen bevorzugten Ausführungsform handelt es sich im Prinzip um eine Sensoranordnung und ein Verfahren zum Erfassen des Aufliegens eines Bedienerkörperteils auf einer Betätigungsstelle einer Kraftfahrzeugschließeinrichtung mit einer kraftsensor-gestützten Nachregelung der Ansprechschwelle eines Annäherungssensors.

Bei einer bevorzugten Weiterbildung wird der von dem Sensorausgangssignalwert des Annäherungssensors abgeleitete Schwellwert für eine vorgegebene Zeitdauer, die etwa einer maximal zu erwartenden Dauer des Aufliegens des Bedienerkörperteils entspricht, gehalten, und anschließend langsam auf einen Ausgangswert abgesenkt. Alternativ kann vorgesehen sein, den Schwellwert unmittelbar nach seiner Einstellung langsam auf den Ausgangswert abfallen zu lassen, wobei die Zeitkonstante des Abfallens deutlich höher gewählt wird als die maximal zu erwartende Dauer des Aufliegens des Bedienerkörperteils.

Der mechanische Sensor ist vorzugsweise ein preiswerter mechanischer Sensor, der insbesondere auf Änderungen der Andruckkraft anspricht, beispielsweise ein piezoelektrischer Sensor oder ein kapazitiver Kraftsensor. Der Sensor umfaßt sowohl einen mit der Außenwandung des Türgriffs gekoppelten Verformungskörper als auch einen mit dem Verformungskörper gekoppelten bzw. in dem Verformungskörper integrierten mechanoelektrischen Wandler. Zusätzlich kann der mechanische Sensor einen Teil der Primärelektronik enthalten. Ein piezoelektrischer Sensor kann daher so ausgebildet sein, daß er ruhestromfrei arbeitet, was den Energieverbrauch weiter minimiert.

Vorteilhafte und/oder bevorzugte Weiterbildungen der Erfindung sind in den Unteransprüchen gekennzeichnet.

Im folgenden wird die Erfindung anhand eines in der Zeichnung dargestellten bevorzugten Ausführungsbeispiels näher erläutert. In den Zeichnungen zeigen:
Figur 1: eine schematische Darstellung eines horizontalen Längsschnitts durch einen Türaußengriff eines Kraftfahrzeugs, wobei der Türaußengriff eine erfindungsgemäße Sensoranordnung enthält;

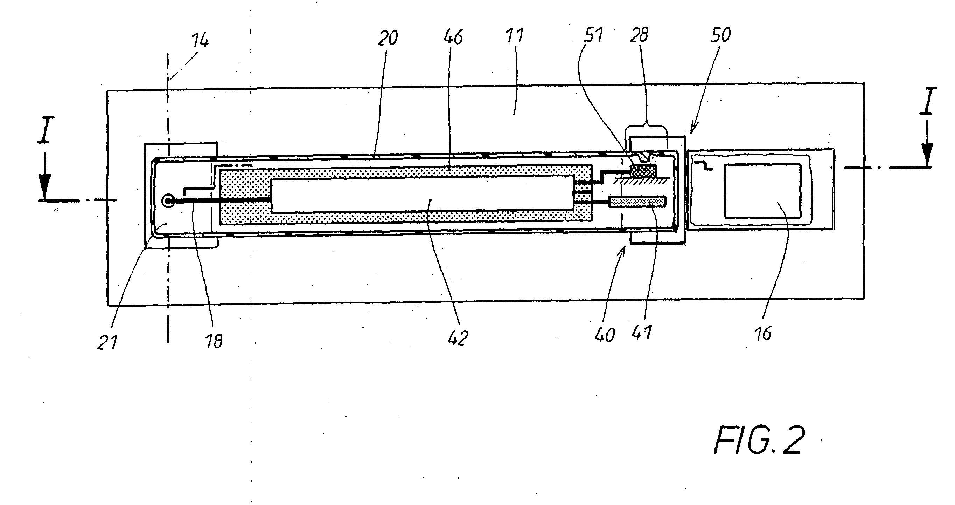

Figur 2: eine schematische Darstellung eines vertikalen Längsschnitts durch den in Figur 1 gezeigten Türaußengriff, geschnitten entlang der Linie II-II;
Figur 3: eine schematische vergrößerte Darstellung desjenigen Teils der in Figur 2 dargestellten Anordnung, der den mechanischen Sensor sowie die Elektrode des kapazitiven Annäherungssensors enthält; und
Figuren 4A - 4C beispielhafte schematische Signalverläufe zur Veranschaulichung der Sensorausgangssignale und des das Aufliegen eines Bedienerkörperteils anzeigenden Ausgabesignals.

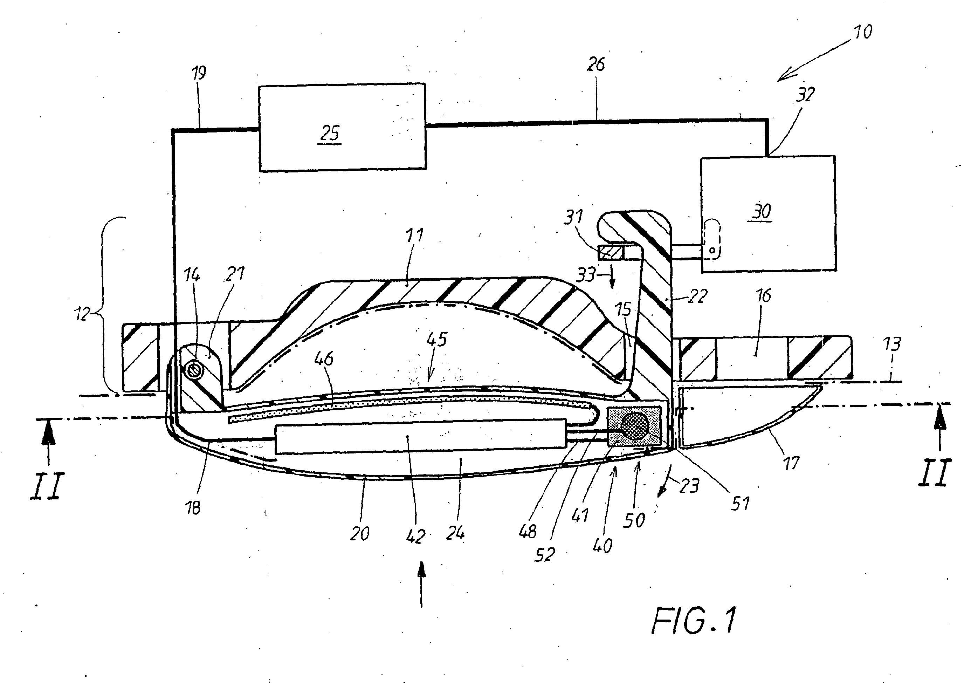

Die in Figur 1 schematisch dargestellte Schließeinrichtung 10 eines Kraftfahrzeugtürgriffs umfaßt einen Träger 11, der im Inneren einer nicht näher dargestellten Tür 12 (von welcher lediglich die Außenverkleidung 13 als Strichpunktlinie angedeutet ist) eines Kraftfahrzeugs montiert ist, einen im Träger 11 gelagerten Griff 20 (auch Handhabe genannt), ein Schloß 30 und eine Steuereinrichtung 25. Der Türgriff 20 ist an einem Ende 21 im Träger 11 schwenkgelagert. Der dargestellte Türgriff ist ein sogenannter "Ziehgriff", bei dem die Schwenklagerung eine im wesentlichen senkrechte Achse 14 aufweist. Das dem Schwenklager gegenüberliegende Ende 22 des Türgriffs 20 besitzt eine einen Durchbruch 15 in der Türaußenverkleidung 13 und im Träger 11 durchgreifende Verlängerung mit einem Hakenende, das ein mechanisches Eingangsglied 31 des in der Tür befindlichen Schlosses 30 hintergreift. Das Schloß 30 hält die Tür 12 normalerweise in der geschlossenen Position. Das Schloß 30 kann sich in einer Verriegelungsstellung und einer Entriegelungsstellung befinden. Wird der Türgriff 20 in Richtung des Pfeils 23 verschwenkt, so wird das Schloßglied 31 in Richtung des Pfeils 33 von dem Hakenende mitgenommen. Befindet sich das Schloß 30 in der Entriegelungsstellung, so gibt das Schloß 30 die Tür frei, und die Tür kann geöffnet werden. Befindet sich das Schloß 30 in der Verriegelungsstellung, so ist diese Betätigung unwirksam; das Schloßglied 31 wird im Leerlauf mitgenommen, ohne daß die Tür freigegeben wird.

Das Schloß kann von der Verriegelungsstellung in die Entriegelungsstellung im Notfall mechanisch, beispielsweise über einen Schließzylinder, überführt werden. Dies ist in Figur 1 nicht näher dargestellt; es ist lediglich ein weiterer Durchbruch 16 im Träger 11 und in der Türaußenverkleidung 13 zu erkennen, in welchem ein Schließzylinder angeordnet sein könnte. Im Normalfall wird das Schloß 30 durch einen elektromechanischen Aktor aus der Verriegelungsstellung in die Entriegelungsstellung und umgekehrt überführt. Die schloßseitigen Anschlüsse 32 des Aktors sind über Zuleitungen 26 mit einem Steuergerät 25 verbunden. Das Steuergerät 25 betätigt die Aktoren der Schlösser 30 eines Kraftfahrzeugs in Abhängigkeit von verschiedenen Eingangssignalen. Unter anderem liefern in dem Türgriff 20 untergebrachte Sensoren (kapazitive Annäherungssensoren 45 und 40 und ein mechanischer Sensor 50) über eine ebenfalls im Türgriff 20 untergebrachte Auswerteschaltung 42 Steuersignale über die Leitungen 18, 19 an das Steuergerät 25. Ein erster kapazitiver Sensor 45 umfaßt eine an der Innenwandung des Türgriffs 20 untergebrachte Elektrode 46.und einen zugehörigen Teil der Auswerteschaltung 42. Ein zweiter kapazitiver Sensor umfaßt eine Elektrode 41 und einen zugehörigen Teil der Auswerteschaltung 42, wobei die Elekrode 41 an der Oberseite des Türgriffs 20 an dem vom Schwenklager 14 beabstandeten Ende angeordnet ist. Der die Elektrode 46 aufweisende erste kapazitive Sensor 45 dient zum Auslösen eines Entriegelungsvorgangs, während der die Elektrode 41 aufweisend zweite kapazitive Sensor 40 zum Auslösen eines Verriegelungsvorgangs des Schlosses 30 dient. Die Auswerteschaltung 42 gibt über die Leitungen 18, 19 Ausgabesignale an das Steuergerät 25 aus, die eine Annäherung bzw. ein Aufliegen eines Bedienerkörperteils an die bzw. auf den Elektroden 46 bzw. 41 anzeigen. Sowohl die Elektrode 46 als auch die Elektrode 41 bauen, wenn der zugehörige Sensor aktiviert ist, ein elektrisches Umgebungsfeld auf. Die Annäherung einer Hand einer Bedienperson bewirkt eine Änderung des elektrischen Feldes (unter anderem durch Änderung der Dielektrizitätskonstante, aber insbesondere durch das mit dem Annähern der Hand verbundene Heranführen eines Massepotentials aufgrund der Kopplung des Bedieners mit Masse (Erde)). Die mit der Änderung der Feldverteilung verbundene Kapazitätserhöhung wird von der Auswerteschaltung 42 erfaßt. Dabei ist der der Elektrode 46 zugeordnete erste kapazitive Sensor empfindlicher eingestellt und erfaßt die Annäherung bereits dann, wenn die Hand noch vom Türgriff beabstandet ist (beispielsweise lediglich in den Raum hinter dem Türgriff eintaucht). Dieser erste kapazitive Sensor 45 ist ständig aktiviert, wobei bei Erfassen der Annäherung der Hand zwischen dem Steuergerät 25 und einem sogenannten ID-Geber (Schlüssel), den der Bediener mit sich führt, ein Funkdialog ausgelöst wird, in dessen Ergebnis eine Zugangsberechtigung des ID-Gebers überprüft wird. Wird die Zugangsberechtigung des in der Nähe befindlichen ID-Gebers festgestellt, so wird das Schloß 30 entriegelt, so daß ein Ziehen am Türgriff 20 eine Öffnung des Schlosses 30 bewirkt. Der erste kapazitive Sensor 45 wird somit als "Öffnungssensor" bezeichnet. Der Öffnungssensor ist nicht Gegenstand der vorliegenden Erfindung.

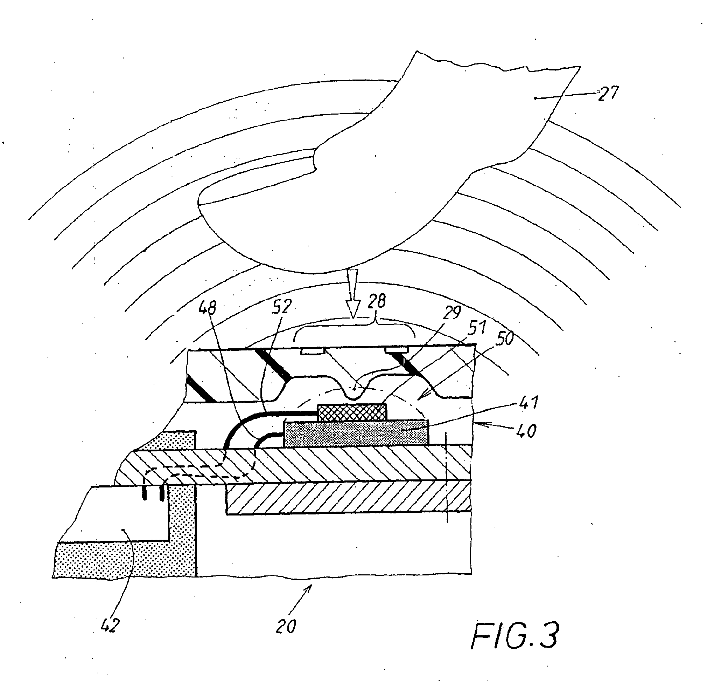

Der zweite kapazitive Sensor 40, der lediglich bei entriegeltem Türschloß 30 aktiviert zu sein braucht, ist weniger empfindlich als der erste kapazitive Sensor, reagiert somit lediglich auf Kapazitätsänderungen, die einem sehr geringen Abstand des Bedienerkörperteils (einem Aufliegen) entsprechen. Dieser kapazitive Sensor 40 löst bei Erfassen des Aufliegens des Bedienerkörperteils einen Verriegelungsvorgang aus und wird deshalb als "Schließsensor" bezeichnet. Der Schließsensor umfaßt erfindungsgemäß nicht nur den kapazitiven Sensor 40, sondern auch den zusätzlichen mechanischen Hilfssensor 50. Der mechanische Hilfssensor 50 ist bei dem in Figur 1 dargestellten Ausführungsbeispiel ein auf geringen mechanischen Druck ansprechender piezoelektrischer Sensor. Die Ausgangssignale des piezoelektrischen Sensors 50 werden ebenfalls von der Auswerteschaltung 42 ausgewertet. Sowohl der kapazitive Hauptsensor 40 als auch der mechanische Hilfssensor 50 sind an der gleichen Betätigungsstelle 28 angeordnet. Dies ist in Figur 3 vergrößert dargestellt. Wenn sich ein Finger 27 an die Betätigungsstelle 28 annähert, so kann dabei - wegen der kapazitiven Fernwirkung - zunächst der kapazitive Annäherungssensor 40 ansprechen. Bei Andrücken des Fingers 27 an die nachgiebige Wandung des Türgriffs an der Betätigungsstelle 28 wird ein Zapfen 29 der Wandung 28 in das Innere des Türgriffs hineinbewegt und wirkt auf ein Piezoelement bzw. einen das Piezoelement enthaltenden Verformungskörper 51 des mechanischen Sensors 50 ein. Die elektrischen Ausgangssignale des Piezoelements werden über die Leitung 52 an die Auswerteschaltung 42 geliefert. Unter dem mechanischen Sensor 50 befindet sich die Elektrode 41 des kapazitiven Annäherungssensors, die über die Leitung 48 ebenfalls mit der Auswerteschaltung 42 verbunden ist.

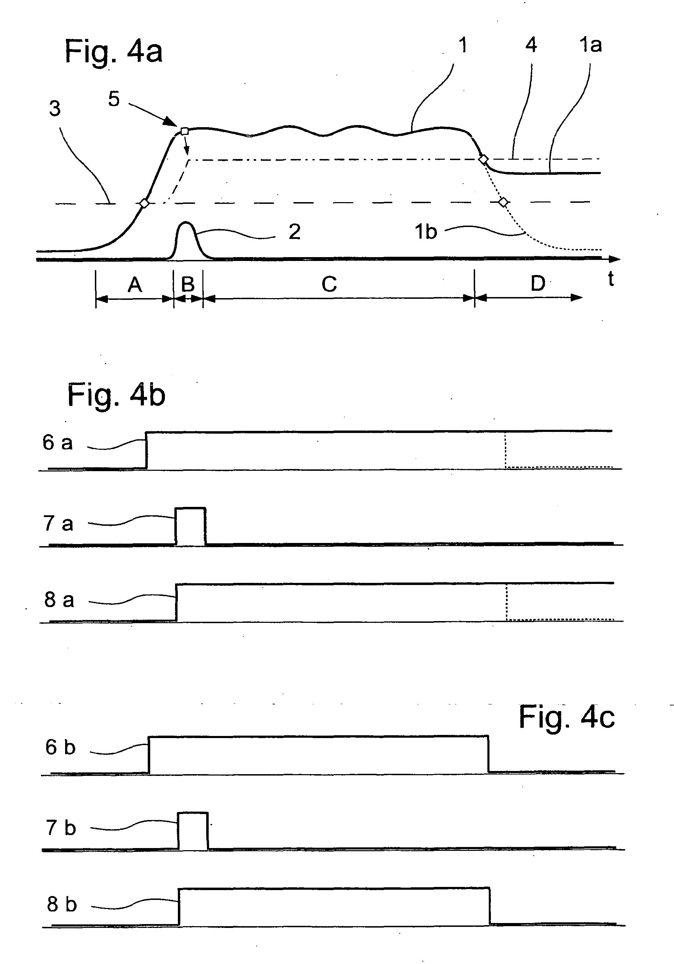

Figuren 4A - 4C veranschaulichen die erfindungsgemäße Auswertung der Ausgangssignale des kapazitiven Annäherungssensors 40 und des mechanischen Sensors 50. Figur 4A zeigt die zeitlichen Verläufe des Sensorausgangssignals 1 des kapazitiven Annäherungssensors und des Sensorausgangssignals 2 des mechanischen Hilfssensors im Verlauf einer Betätigung der Sensoranordnung.

Im Intervall A nähert sich ein Bedienerkörperteil, beispielsweise der Daumen des Bedieners, an die Betätigungsstelle 28 an. Dabei steigt die Kapazität und somit das Sensorausgangssignal 1 des Annäherungssensors an. Das Sensorausgangssignal 2 bleibt unverändert. Sobald der Finger des Bedieners im Intervall B auf die Betätigungsstelle 28 aufgelegt wird und eine Druckkraft ausübt, gibt der mechanische Sensor einen Ausgangsimpuls aus. Im Intervall C bleibt der Finger auf der Betätigungsstelle 28 liegen, ohne daß die Andruckkraft wesentlich verändert wird. Im Intervall D wird der Finger von der Betätigungsstelle 28 entfernt. Das Sensorausgangssignal 1 des kapazitiven Sensors bleibt bei aufliegendem Finger auf einem relativ hohen Wert und sinkt beim Wegnehmen des Fingers ab. Zum Erfassen des Aufliegens des Fingers wird das Ausgangssignal 1 des kapazitiven Sensors mit einem Schwellwert 3 verglichen. Bei einer bekannten Anordnung ist der Schwellwert 3 konstant (Strich-Linie). So wird im Intervall A ein Überschreiten des Sensorausgangssignals 1 über den Schwellwert 3 als Annäherung des Bedienerkörperteils gewertet. Nach Wegnehmen des Fingers im Intervall D sinkt das Sensorausgangssignal 1 wieder ab, im Normalfall entlang der Linie 1b, wobei der Schwellwert 3 wieder unterschritten wird, was eine Erfassung des Wegnehmens gestattet. Es kann jedoch der Fall eintreten, daß beim Wegnehmen des Fingers das Sensorausgangssignal 1 weniger stark abfällt und sich ein Verlauf entlang der in Figur 4a dargestellten Linie 1a ergibt. Das Sensorausgangssignal (die Kapazität) des kapazitiven Sensors fällt zwar ab, unterschreitet jedoch nicht mehr den Schwellwert 3. Ursache dafür kann eine durch die Betätigung verursachte Verschmutzung verbunden mit Feuchtigkeit sein. Bei der herkömmlichen Anordnung würde eine Auswertung des Sensorausgangssignals 1 des kapazitiven Sensors keine Feststellung des Wegnehmens des Fingers gestatten. Auch ein Hinzuziehen des zusätzlichen Ausgangssignals 2 des mechanischen Hilfssensors würde die Feststellung des Wegnehmens nicht ermöglichen.

Hier setzt die Erfindung ein. Wenn im Intervall B aufgrund des Ausgangssignals 2 des mechanischen Sensors das mit dem Auflegen verbundene Andrücken des Fingers festgestellt wird, so wird der zu diesem Zeitpunkt erfaßte Wert 5 des Sensorausgangssignals 1 des kapazitiven Sensors verwendet, um daraus einen neuen Schwellwert 4 abzuleiten. Der Schwellwert wird von der Ausgangslinie 3 im Intervall B entlang der Strich-Punkt-Linie 4 angehoben. Im weiteren Verlauf (Intervalle C und D) wird dann das Sensorausgangssignal 1 des kapazitiven Sensors mit dem Schwellwert 4 verglichen. Dies gestattet ein sicheres Feststellen des Wegnehmens des Fingers auch dann, wenn sich infolge von Verschmutzung/Feuchtigkeit das Ausgangssignal entlang der Linie 1a bewegt. Auch dieses verschmutzungsbedingte höhere Sensorausgangssignal 1A unterschreitet den (angehobenen) Schwellwert 4.

Figuren 4B und 4C zeigen die aus den Sensorsignalen abgeleiteten binären Auswertesignale des kapazitiven Annäherungsensors 6a, 6b und des mechanischen Hilfssensors 7a, 7b und das das Aufliegen des Bedienerkörperteils anzeigende Ausgabesignal 8a, 8b sowohl für die im Stand der Technik bekannte Anordnung (Figur 4B) als auch für die erfindungsgemäße Anordnung (Figur 4C). Im Stand der Technik gemäß Figur 4B zeigt das Auswertesignal 6a des kapazitiven Annäherungssensors ein Aufliegen des Fingers an, wenn das Sensorausgangssignal 1 den Schwellwert 3 überschreitet. Das Wegnehmen wird nur für den gestrichelt dargestellten Fall des Signalverlaufs 1b der Figur 4A erfaßt. Das Aufliegen des Fingers wird durch das Ausgabesignal 8a angezeigt, wenn nach anliegendem Auswertesignal 6a zusätzlich kurzzeitig das Auswertesignal 7a des mechanischen Sensors eintrifft. Anschließend bleibt das Ausgabesignal 8a solange auf hohem Pegel, bis das Sensorausgangssignal 1 des kapazitiven Sensors wieder unter den Schwellwert 3 abfällt, was aber nach Wegnehmen des Fingers nur im Fall 1b festgestellt werden kann.

Figur 4C zeigt die entsprechenden Verläufe bei der erfindungsgemäßen Vorgehensweise Auch hier wird das das Aufliegen des Fingers anzeigende Ausgabesignal 8b erst dann erzeugt, wenn sowohl der kapazitive Sensor 40 als auch der mechanische Sensor 50 ein entsprechendes Ausgangssignal erzeugt haben. Anschließend wird das Sensorausgangssignal 1 des kapazitiven Sensors mit dem angepaßten Schwellwert 4 verglichen, so daß bei Wegnehmen des Fingers das Auswertesignal 6b auch dann wieder auf Null abfällt, wenn sich der in Figur 4A dargestellte Signalverlauf 1a ergibt. Somit zeigt das Ausgabesignal 8b exakt das Wegenehmen des Fingers an.

## Patentansprüche

1. Sensoranordnung zum Erfassen des Aufliegens eines Bedienerkörperteils (27) auf einer Betätigungsstelle (28) einer Schließeinrichtung (10) eines Kraftfahrzeugs,
mit einem Annäherungssensor (40), der so angeordnet ist, daß der Annäherungssensor (40) eine Annäherung des Bedienerkörperteils (27) an die Betätigungsstelle (28) erfassen kann,
mit einem an der Betätigungsstelle (28) angeordneten mechanischen Sensor (50), der eine Änderung einer von dem Bedienerkörperteil (27) auf die Betätigungsstelle (28) ausgeübten Druckkraft erfassen kann,
und mit einer Auswerteschaltung (42), die in Abhängigkeit von den Sensorausgangssignalen (1, 2) des Annäherungssensors (40) und des mechanischen Sensors (50) ein das Aufliegen des Bedienerkörperteils (27) anzeigendes Ausgabesignal (8b) erzeugen kann,
**dadurch gekennzeichnet,**
**daß** die Auswerteschaltung (42) dann, wenn das Sensorausgangssignal (2) des mechanischen Sensors (50) den Beginn des Aufliegens des Bedienerkörperteils (27) anzeigt, einen etwa gleichzeitig vom Annäherungssensor (40) ausgegebenen Sensorausgangssignalwert (5) für eine Auswertung der nachfolgenden Änderungen des Sensorausgangssignals (1) des Annäherungssensors (40) heranzieht, um ein Wegnehmen des Bedienerkörperteils (27) von der Betätigungsstelle (28) sicherer erfassen zu können.

2. Sensoranordnung nach Anspruch 1, **dadurch gekennzeichnet, daß** der Annäherungssensor ein kapazitiver Annäherungssensor (40) ist, der wenigstens eine Elektrode (41) aufweist, die so angeordnet ist, daß der kapazitive Annäherungssensor (40) eine Annäherung an die Betätigungsstelle (28) erfassen kann.

3. Sensoranordnung nach Anspruch 1 oder 2, **dadurch gekennzeichnet, daß** das Sensorausgangssignal (2) des mechanischen Sensors (50) den Beginn des Aufliegens des Bedienerkörperteils (27) anzeigt, indem es mit einer sprunghaften Signaländerung eine sprunghafte Zunahme der ausgeübten Druckkraft anzeigt.

4. Sensoranordnung nach einem der Ansprüche 1 - 3, **dadurch gekennzeichnet, daß** die Auswerteschaltung (42) den gleichzeitig vom Annäherungssensor (40) ausgegebenen Sensorausgangssignalwert (5) für eine Auswertung der nachfolgenden Änderungen des Sensorausgangssignals (1) heranzieht, indem sie aus dem gleichzeitig vom Annäherungssensor (40) ausgegebenen Sensorausgangssignalwert (5) einen Schwellwert (4) ableitet, nachfolgend das Sensorausgangssignal (1) des kapazitiven Annäherungssensors (40) mit dem Schwellwert (4) vergleicht und eine das Wegnehmen des Bedienerkörperteils (27) anzeigende Änderung des Ausgabesignals (8b) bewirkt, wenn das Sensorausgangssignal (1a) des Annäherungssensors (40) den Schwellwert (4) unterschreitet.

5. Sensoranordnung nach Anspruch 4, **dadurch gekennzeichnet, daß** die Auswerteschaltung (42) den Schwellwert (4) für eine vorgegebene Zeitdauer, die etwa einer maximal zu erwartenden Dauer des Aufliegens des Bedienerkörperteils (27) entspricht, hält und dann den Schwellwert langsam auf einen Ausgangswert (3) absenkt.

6. Sensoranordnung nach einem der Ansprüche 1 - 5, **dadurch gekennzeichnet, daß** der mechanische Sensor (50) ein piezoelektrischer Sensor oder ein kapazitiver Kraftsensor ist.

7. Sensoranordnung nach einem der Ansprüche 1 - 6, **dadurch gekennzeichnet, daß** im montierten Zustand sich die Betätigungsstelle (28) auf einem Kraftfahrzeugtürgriff (20) befindet.

8. Sensoranordnung nach Anspruch 7, **dadurch gekennzeichnet, daß** im montierten Zustand der mechanische Sensor (50) zwischen einer Elektrode (41) eines kapazitiven Annäherungssensors (40) und einer durchbiegbaren Außenwandung (28) des Kraftfahrzeugtürgriffs (20) angeordnet ist.

9. Sensoranordnung nach Anspruch 7, **dadurch gekennzeichnet, daß** der mechanische Sensor unter einer Elektrode eines kapazitiven Annäherungssensors angeordnet ist, wobei im montierten Zustand die Elektrode und eine darüberliegende Außenwandung des Kraftfahrzeugtürgriffs so ausgebildet sind, daß sie eine Übertragung einer Druckkraft auf den mechanischen Sensor gestatten.

10. Verfahren zum Erfassen des Aufliegens eines Bedienerkörperteils (27) auf einer Betätigungsstelle (28) einer Schließeinrichtung (10) eines Kraftfahrzeugs, wobei:
mit einem Annäherungssensor (40) eine Annäherung des Bedienerkörperteils (27) an die Betätigungsstelle (28) erfaßt wird,
mit einem an der Betätigungsstelle (28) angeordneten mechanischen Sensor (50) eine Änderung einer von dem Bedienerkörperteil (27) auf die Betätigungsstelle (28) ausgeübten Druckkraft erfaßt wird und
von einer Auswerteschaltung (42) in Abhängigkeit von den Sensorausgangssignalen (1, 2) des Annäherungssensors (40) und des mechanischen Sensors (50) ein das Aufliegen des Bedienerkörperteils (27) anzeigendes Ausgabesignal (8b) erzeugt wird,
**dadurch gekennzeichnet,**
**daß** dann, wenn von der Auswerteschaltung (42) aufgrund des Sensorausgangssignals (2) des mechanischen Sensors (50) der Beginn des Aufliegens des Bedienerkörperteils (27) erfaßt wird, ein etwa gleichzeitig vom Annäherungssensor (40) ausgegebener Sensorausgangssignalwert (5) erfaßt und für eine Auswertung der nachfolgenden Änderungen des Sensorausgangssignals (1) des Annäherungssensors (40) herangezogen wird, um ein Wegnehmen des Bedienerkörperteils (27) von der Betätigungsstelle (28) sicherer erfassen zu können.

11. Verfahren nach Anspruch 10, **dadurch gekennzeichnet, daß** von dem Sensorausgangssignal (2) des mechanischen Sensors (50) der Beginn des Aufliegens des Bedienerkörperteils (27) angezeigt wird, indem mit einer sprunghaften Signaländerung eine sprunghafte Zunahme der ausgeübten Druckkraft angezeigt wird.

12. Verfahren nach Anspruch 10 oder 11, **dadurch gekennzeichnet, daß** von der Auswerteschaltung (42) der gleichzeitig vom Annäherungssensor (40) ausgegebene Sensorausgangssignalwert (5) erfaßt und für eine Auswertung der nachfolgenden Änderungen des Sensorausgangssignals (1) des Annäherungssensors (40) herangezogen wird, indem:
aus dem gleichzeitig vom Annäherungssensor (40) ausgegebenen Sensorausgangssignalwert (5) ein Schwellwert (4) abgeleitet wird,
nachfolgend das Sensorausgangssignal (1) des Annäherungssensors (40) mit dem Schwellwert (4) verglichen wird, und
eine das Wegnehmen des Bedienerkörperteils (27) anzeigende Änderung des Ausgabesignals (8b) erzeugt wird, sobald das Sensorausgangssignal (1) des Annäherungssensors (40) den Schwellwert (4) unterschreitet.

13. Verfahren nach Anspruch 12, **dadurch gekennzeichnet, daß** der Schwellwert (4) für eine vorgegebene Zeitdauer, die etwa einer maximal zu erwartenden Dauer des Aufliegens des Bedieherkörperteils (27) entspricht, gehalten und dann langsam auf einen Ausgangswert (3) abgesenkt wird.

## Claims

1. A sensor arrangement for detecting the engagement of a user body portion (27) with an actuating point (28) of a closing device (10) of a motor vehicle, including a proximity sensor (40), which is so arranged that the proximity sensor (40) can detect the approach of the user body portion (27) to the actuating point (28), a mechanical sensor (50), which is arranged at the actuating point (28) and can detect a change in a pressure exerted by the user body portion (27) on the actuating point (28), and a computing circuit (42), which can produce an output signal (8b) indicative of the engagement of the user body portion (27) in dependence on the sensor output signals (1, 2) of the proximity sensor (40) and of the mechanical sensor (50), **characterised in that** when the sensor output signal (2) of the mechanical sensor (50) indicates the beginning of the engagement of the user body portion (27), the computing circuit (42) utilises a sensor output signal value (5) produced approximately simultaneously by the proximity sensor (40) to analyse the subsequent changes in the sensor output signal (1) from the proximity sensor (40) in order to be able more reliably to detect removal of the user body portion (27) from the actuating point (28).

2. A sensor arrangement as claimed in claim 1, **characterised in that** the proximity sensor is a capacitive proximity sensor (40), which includes at least one electrode (41), which is so arranged that the capacitive proximity sensor (40) can detect an approach to the actuating point (28).

3. A sensor arrangement as claimed in claim 1 or 2, **characterised in that** the sensor output signal (2) of the mechanical sensor (50) indicates the beginning of the engagement of the user body portion (27) by indicating an abrupt increase in the pressure exerted with an abrupt change in the signal.

4. A sensor arrangement as claimed in one of claims 1 to 3, **characterised in that** the computing circuit (42) utilises the sensor output signal value (5) produced simultaneously by the proximity sensor (40) for an analysis of the subsequent changes in the sensor output signal (1) by deriving a threshold value (4) from the sensor output signal value (5) produced simultaneously by the proximity sensor (4), then comparing the sensor output signal (1) of the capacitive proximity sensor (40) with the threshold value (4) and causing a change in the output signal (8b) indicative of the removal of the user body portion (27) when the sensor output signal (1a) of the proximity sensor (40) falls below the threshold value (4).

5. A sensor arrangement as claimed in claim 4, **characterised in that** the computing circuit (42) holds the threshold value (4) for a predetermined period of time, which approximately corresponds to a maximum duration to be expected of the engagement of the user body portion (27) and then reduces the threshold value slowly to a starting value (3).

6. A sensor arrangement as claimed in one of claims 1 to 5, **characterised in that** the mechanical sensor (50) is a piezoelectric electric sensor or a capacitive force sensor.

7. A sensor arrangement as claimed in one of claims 1 to 6, **characterised in that** the actuating point (28) is situated, in the installed state, on a motor vehicle door handle (20).

8. A sensor arrangement as claimed in claim 7, **characterised in that** the mechanical sensor (50) is arranged, in the installed state, between an electrode (41) of a capacitive proximity sensor (40) and a deflectable outer wall (28) of the motor vehicle door handle (20).

9. A sensor arrangement as claimed in claim 7, **characterised in that** the mechanical sensor is arranged below an electrode of a capacitive proximity sensor, wherein, in the installed state, the electrode and an outer wall situated above it of the motor vehicle door handle are so constructed that they permit the transfer of a pressure to the mechanical sensor.

10. A method of detecting the engagement of a user body portion (27) to an actuating point (28) of a closing device (10) of a motor vehicle, wherein:
an approach of the user body portion (27) to the actuating point (28) is detected with a proximity sensor (40), a change in a pressure exerted by the user body portion (27) on the actuating point (28) is detected with a mechanical sensor (50) arranged at the actuating point (28) and an output signal (8b) indicative of the engagement of the user body portion (27) is produced by a computing circuit (42) in dependence on the sensor output signals (1, 2) of the proximity sensor (40) and the mechanical sensor (50), **characterised in that**, when the beginning of the engagement of the user body portion (27) is detected by the computing circuit (42) on the basis of the sensor output signal (2) of the mechanical sensor (50), a sensor output signal value (5) produced approximately simultaneously by the proximity sensor (40) is detected and utilised for an analysis of the subsequent changes in the sensor output signal (1) of the proximity sensor (40) in order to be able more reliably to detect removal of the user body portion (27) from the actuating point (28).

11. A method as claimed in claim 10, **characterised in that** the beginning of the engagement of the user body portion (27) is indicated by the sensor output signal (22) of the mechanical sensor (50) by indicating an abrupt increase of the pressure exerted with an abrupt change in signal.

12. A method as claimed in claim 10 or 11, **characterised in that** the sensor output signal value (5) produced simultaneously by the proximity sensor (40) is detected by the computing circuit (42) and utilised for an analysis of the subsequent changes in the sensor output signal (1) of the proximity sensor (40) by:
deriving a threshold value (4) from the sensor output signal value (5) produced simultaneously by the proximity sensor (40), then comparing the sensor output signal (1) of the proximity sensor (40) with the threshold value (4) and causing a change in the output signal (8b) indicative of the removal of the user body portion (27) as soon as the sensor output signal (1) of the proximity sensor (40) falls below the threshold value (4).

13. A method as claimed in claim 12, **characterised in that** the threshold value (4) is held for a predetermined period of time, which approximately corresponds to a maximum duration to be expected of the engagement of the user body portion (27) and is then slowly reduced to a starting value (3).

## Revendications

1. Agencement de capteur pour détecter l'appui d'une partie de corps (27) d'un utilisateur sur un point de commande (28) d'un dispositif de fermeture (10) d'un véhicule automobile,
comprenant un capteur de proximité (40) qui est aménagé de sorte que le capteur de proximité (40) puisse détecter une approche de la partie de corps (27) de l'utilisateur sur le point de commande (28),
un capteur mécanique (50) aménagé sur le point de commande (28), qui peut détecter une variation d'une force de pression exercée par la partie de corps (27) de l'utilisateur sur le point de commande (28),
et un circuit d'exploitation (42) qui peut générer, en fonction des signaux de sortie (1, 2) du capteur de proximité (40) et du capteur mécanique (50), un signal de sortie (8b) indiquant l'appui de la partie de corps (27) de l'utilisateur,
**caractérisé en ce que**
le circuit d'exploitation (42), lorsque le signal de sortie (2) du capteur mécanique (50) indique le début de l'appui de la partie de corps (27) de l'utilisateur, prend en compte une valeur (5) du signal de sortie du capteur délivrée à peu près en même temps par le capteur de proximité (40) pour une exploitation des variations suivantes du signal de sortie (1) du capteur de proximité (40) afin de pouvoir détecter plus sûrement un retrait de la partie de corps (27) de l'utilisateur du point de commande (28).

2. Agencement de capteur selon la revendication 1, **caractérisé en ce que** le capteur de proximité est un capteur de proximité capacitif (40), qui présente au moins une électrode (41) qui est aménagée de sorte que le capteur de proximité capacitif (40) puisse détecter une approche sur le point de commande (28).

3. Agencement de capteur selon la revendication 1 ou 2, **caractérisé en ce que** le signal de sortie (2) du capteur mécanique (50) indique le début de l'appui de la partie de corps (27) de l'utilisateur en affichant, avec une brusque variation de signal, une augmentation brusque de la force de pression exercée.

4. Agencement de capteur selon l'une quelconque des revendications 1 à 3, **caractérisé en ce que** le circuit d'exploitation (42) prend en compte la valeur (5) du signal de sortie du capteur délivrée en même temps par le capteur de proximité (40) pour une exploitation des variations suivantes du signal de sortie (1) du capteur en déduisant de la valeur (5) du signal de sortie du capteur, délivrée en même temps par le capteur de proximité (40), une valeur de seuil (4), en comparant ensuite le signal de sortie (1) du capteur de proximité capacitif (40) à la valeur de seuil (4) et en provoquant une variation du signal de sortie (8) indiquant le retrait de la partie de corps (27) de l'utilisateur, lorsque le signal de sortie (1a) du capteur de proximité (40) se trouve en dessous de la valeur de seuil (4).

5. Agencement de capteur selon la revendication 4, **caractérisé en ce que** le circuit d'exploitation (42) conserve la valeur de seuil (4) pendant une période de temps prédéfinie, correspondant à peu près à une durée de l'appui de la partie de corps (27) de l'utilisateur à escompter au maximum, et abaisse ensuite la valeur de seuil lentement à une valeur de sortie (3).

6. Agencement de capteur selon l'une quelconque des revendications 1 à 5, **caractérisé en ce que** le capteur mécanique (50) est un capteur piézoélectrique ou un capteur de force capacitif.

7. Agencement de capteur selon l'une quelconque des revendications 1 à 6, **caractérisé en ce qu'**à l'état monté, le point de commande (28) se trouve sur une poignée de porte (20) du véhicule automobile.

8. Agencement de capteur selon la revendication 7, **caractérisé en ce qu'**à l'état monté, le capteur mécanique (50) est aménagé entre une électrode (41) d'un capteur de proximité capacitif (40) et une paroi externe déformable (28) de la poigne de porte (20) du véhicule automobile.

9. Agencement de capteur selon la revendication 7, **caractérisé en ce que** le capteur mécanique est aménagé en dessous d'une électrode d'un capteur de proximité capacitif, dans lequel, à l'état monté, l'électrode et une paroi externe, appliquée pardessus, de la poignée de porte du véhicule automobile sont conformées de manière à permettre une transmission d'une force de pression sur le capteur mécanique.

10. Procédé de détection de l'appui d'une partie de corps (27) d'un utilisateur sur un point de commande (28) d'un dispositif de fermeture (10) d'un véhicule automobile, dans lequel :
un capteur de proximité (40) détecte une approche de la partie de corps (27) de l'utilisateur sur le point de commande (28),
un capteur mécanique (50) aménagé sur le point de commande (28) détecte une variation d'une force de pression exercée par la partie de corps (27) de l'utilisateur sur le point de commande (28), et
un signal de sortie (8b) indiquant l'appui de la partie de corps (27) de l'utilisateur est généré par un circuit d'exploitation (42) en fonction des signaux de sortie (1, 2) du capteur de proximité (40) et du capteur mécanique (50),
**caractérisé en ce que**,
lorsque le début de l'appui de la partie de corps (27) de l'utilisateur est détecté par le circuit d'exploitation (42) en raison du signal de sortie (2) du capteur mécanique (50), une valeur (5) du signal de sortie du capteur délivrée à peu près en même temps par le capteur de proximité (40) est détectée et prise en compte pour une exploitation des variations suivantes du signal de sortie (1) du capteur de proximité (40) pour pouvoir détecter plus sûrement un retrait de la partie de corps (27) de l'utilisateur du point de commande (28).

11. Procédé selon la revendication 10, **caractérisé en ce que** le début de l'appui de la partie de corps (27) de l'utilisateur est indiquée par le signal de sortie (2) du capteur mécanique (50) en montrant, avec une brusque variation du signal, une augmentation brusque de la force de pression exercée.

12. Procédé selon la revendication 10 ou 11, **caractérisé en ce que** la valeur (5) du signal de sortie du capteur délivrée en même temps par le capteur de proximité (40) est détectée par le circuit d'exploitation (42) et prise en compte pour une exploitation des variations suivantes du signal de sortie (1) du capteur de proximité (40),
en déduisant de la valeur (5) du signal de sortie du capteur, délivrée en même temps par le capteur de proximité (40), une valeur de seuil (4),
en comparant ensuite le signal de sortie (1) du capteur de proximité (40) à la valeur de seuil (4), et
en générant une variation du signal à la sortie (8b) indiquant le retrait de la partie de corps (27) de l'utilisateur, dès lors que le signal de sortie (1) du capteur de proximité (40) se trouve en dessous de la valeur de seuil (4).

13. Procédé selon la revendication 12, **caractérisé en ce que** la valeur de seuil (4) est conservée pendant une période de temps prédéfinie, correspondant à peu près à une durée de l'appui de la partie de corps (27) de l'utilisateur à escompter au maximum, et abaissée ensuite lentement à une valeur de sortie (3).
